# EUROPEAN PATENT SPECIFICATION

(11) **EP 1 901 396 B1**
(45) Date of publication and mention of the grant of the patent: **20.01.2010**
(21) Application number: 07115515.4
(22) Date of filing: 03.09.2007
(51) Int. Cl.: H01R 12/04

(54) **Low cost clamp for electric/electronic applications to be mounted on printed circuits**
Kostengünstige Klemme zur Montage elektrischer/elektronischer Geräte auf Leiterplatten
Pince à faible coût pour des appareils électriques/électroniques à monter sur des circuits imprimés

(30) Priority: 12.09.2006 IT PD20060339
(43) Date of publication of application: 19.03.2008
(73) Proprietor: Manca, Claudio, 35127 Padova (IT)
(72) Inventor: Manca, Claudio, 35127 Padova (IT)
(74) Representative: Vinci, Marcello

(56) References cited:
- GB-A- 1 381 025
- US-A1- 2001 019 904

## Description

The present patent concerns clamps for the connection of electric cables or wires of various diameter and current capacity for electric and/or electronic devices or for parts of them. In particular it concerns clamps which are mounted on printed circuits, comprising a flat rigid body with paths or tracks made of copper or other conductive metal.

The electronic devices are generally made of one or more printed circuits electrically interconnected by means of electric cables and/or wires.

Said printed circuits are generally also connected to other components and/or devices such as, among others, power supply sources and/or buttons and/or switches, again by means of electric cables of various diameter and current capacity.

The connection to these cables or wires is generally made by means of electromechanical components called clamps which, once welded to the printed circuit tracks, keep the cable in position, at the same time guaranteeing electrical continuity.

GB-A-1381025 and US-A-2001/019904 are examples of clamps.

For connection of these electric and/or electronic devices or parts of them to the electric cables or wires, screw clamps with or without contact plate and/or spring clamps are preferred.

These products generally consist of several components. In the case of the clamps with screw and contact plate, the components are: a metal screw, a metal barrel with a threaded hole for insertion of the screw and a square or round hole for insertion of the wire, a metal terminal which is positioned in contact with the wire via the barrel and rotation of the screw and which conveys the electric signal to the printed circuit, the point at which said terminal is welded.

In the case of the screw clamp without contact plate, the components are:
a screw, a barrel with a threaded hole for insertion of the screw and a square or round hole for insertion of the wire, a terminal if necessary which is positioned in contact with the wire via the barrel and rotation of the screw. The electric signal is conveyed to the printed circuit via the terminal or via a contact obtained directly from the barrel which is welded on the copper track.

The above components are supported and covered by a shell made of thermoplastic material.

This type of screw clamp entails the following production and operating problems.

### Production problems:

The screw clamp consists of a minimum of two metal components plus the thermoplastic shell.

In the screw clamp of the type with contact plate, the minimum number of metal components is three plus the thermoplastic shell.

The thermoplastic shell is essential for correct operation of the clamp as it provides the supporting structure. This means that the clamp has a certain cost at least equal to the sum of the costs of the individual elements with the addition of the assembly cost.

Production of the clamps also involves the problem of assembly of the components by hand or with specific machinery in order to obtain the finished product.

The cost of the machinery makes it particularly complex and costly to produce clamps for specific applications.

### Operating problems:

The screw clamps for printed circuits (of the type with contact plate and otherwise) must be welded on the printed circuit to which the electric wires are to be connected. This further operation represents a cost for the manufacturer of the electronic and/or electric device.

It is not unusual, due to vibration during use, for the screws securing the cable or wire to come loose thus creating false contacts and resulting in malfunctioning of the device.

The spring clamp involves similar production and operating problems, as specified below.

### Production problems:

The spring clamp consists of a minimum of two metal components welded together or mechanically assembled plus the thermoplastic shell as the spring is made of a material that permits greater mechanical stress, whereas for the contact part a material with superior electric conductivity is used. Said contact is then welded on the printed circuit.

Also in this case the thermoplastic shell is essential for correct operation of the clamp, as it provides the supporting structure.

This means that the clamp has a certain cost at least equal to the sum of the costs of the individual elements with the addition of the assembly cost.

Production of the clamps also involves the problem of assembly of the components by hand or with specific machinery in order to obtain the finished product.

The cost of the machinery makes it particularly complex and costly to produce clamps for specific applications.

### Operating problems:

The spring clamps for printed circuits must be welded on the printed circuit to which the electric wires are to be connected.

This further operation represents a cost for the manufacturer of the electronic and/or electric device.

To remedy all the above drawbacks, a new low cost clamp has been devised for mounting on printed circuits.

The object of the invention is to produce a new clamp with a reduced number of components, which would reduce the cost of the clamp itself.

A further object of the invention is to eliminate the cost of assembly of the clamp during production, reducing the cost of the clamp itself and permitting easy adaptability thereof to specific application requirements.

A further object of the new clamp is to avoid the need for welding on the printed circuit, making assembly of the clamp cheaper. The cost of assembly and connection of the new clamp is comparable to the cost of connection of the old clamps to the electric cables but the cost of welding of the same on the printed circuit is eliminated.

A further object of the new clamp is to avoid malfunctions of the devices due to vibrations.

These and other direct and complementary objects are achieved by the new clamp comprising one single component (by way of non-limiting example, made of metal), applicable near the edge of the printed circuit by insertion of apposite hooks in corresponding positioning holes or seats obtained on the printed circuit itself at a distance from the edge equal to the length of the contact to be guaranteed. The clamp has a parallelepiped shape and is provided with positioning hooks at the end.

Said hooks connect to said positioning holes or seats on the printed circuit.

On the opposite side of the clamp, retaining hooks are provided, fixed to the edge of the printed circuit.

The parallelepiped will furthermore be hollow and open on the lower side, which rests on the printed circuit, to permit contact of the electric wire directly on a track of the printed circuit purposely produced to create electric continuity between wire and circuit. On the upper side of the parallelepiped a flexible tab will be provided which, once the new clamp has been hooked to the printed circuit, will have the function of ensuring, with a constant pressure, the electric contact between the cable and the printed circuit track below as well as mechanical stability of the electric cable.

The electric cable or wire will be inserted in the new clamp since the latter, though being constrained by the positioning hooks inserted in the holes of the printed circuit, will still be able to rotate using said hooks as a fulcrum. The rotation with respect to said fulcrum performed by pushing the new clamp towards the printed circuit will result in the electric cable inserted inside the same being positioned in contact with a track provided on the printed circuit, with a constant pressure due to the upper flexible tab.

The retaining hooks will connect to the edge of the printed circuit so as to be fixed to it, thus closing the clamp in the working position.

The characteristics of the new low cost clamp for printed circuits will be better clarified by the following description with reference to the drawings attached by way of non-limiting example.

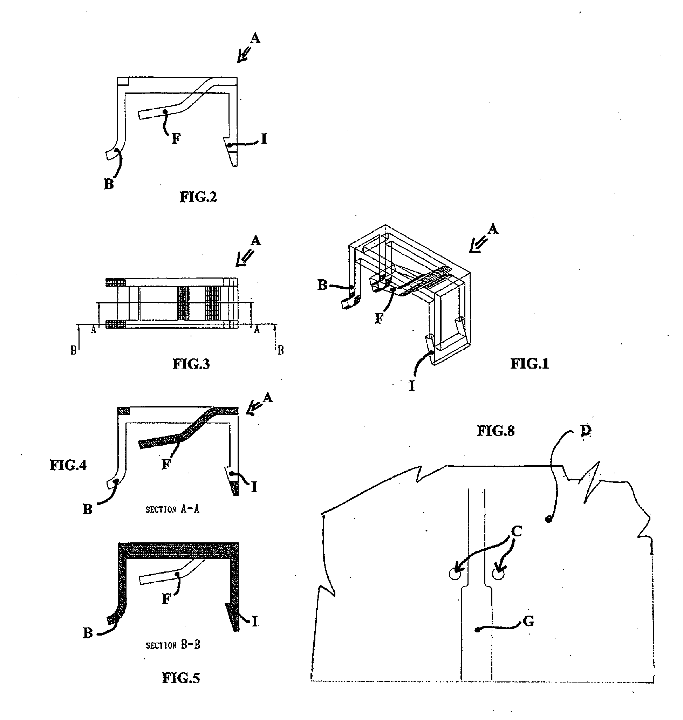

Figure 1 shows an axonometric view of the body or structure (A) while figures 2, 3 show a lateral view and a plan view of the same, respectively.

Figures 4 and 5 show sections of said body or structure (A): Figure 4 highlights the tab or flexible part (F) and Figure 5 highlights the positioning hooks (B) and the retaining hooks (I).

Figure 8 shows the printed circuit (D) with the insertion holes (C) for the positioning hooks (B) and a path or track (G).

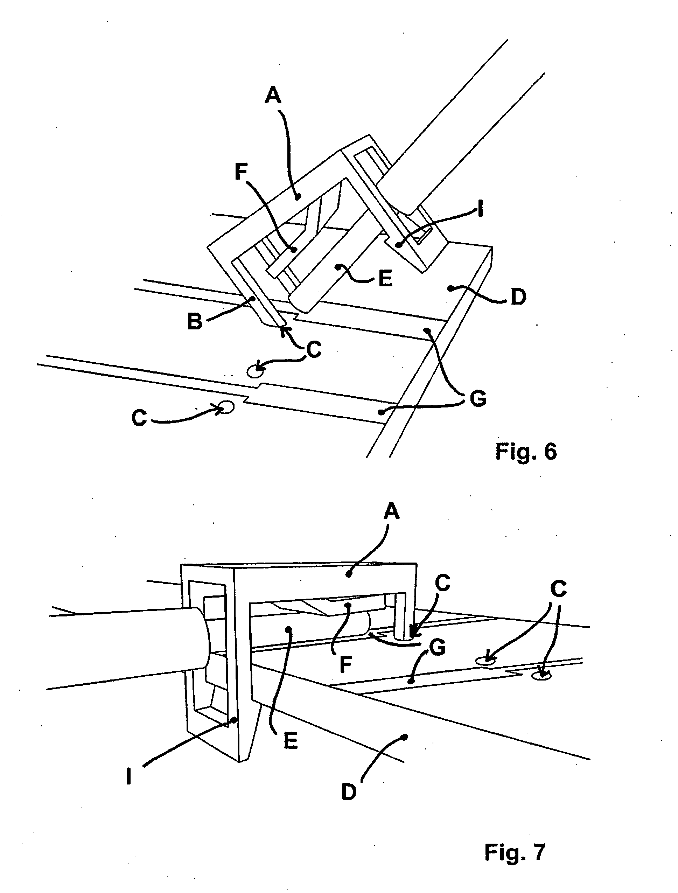

Figures 6 and 7 show the clamp open and closed, respectively.

The body or structure (A) has a generically parallelepiped external shape and is made in such a way as to be hollow in the part in contact with the printed circuit.

The structure (A) is provided with positioning hooks (B) which engage in suitable positioning holes (C) of the printed circuit (D). Said positioning hooks (B) permit assembly of the clamp on the printed circuit (D), leaving the structure (A) free for insertion of the cable or wire (E) to be connected to the printed circuit (D).

Figure 6 shows the clamp in the so-called open configuration, with the cable or wire (E).

Said positioning hooks (B) are made in such a way that said body or structure (A) is free to rotate as far as the so-called closed position, or operating position, highlighted in Figure 7.

The upper horizontal wall of the structure (A) is provided with at least one flexible tab (F), the function of which is to keep the cable in position against the path or track (G) obtained on the printed circuit (D), thus creating the electrical contact between the wire (E) and the track (G), in the so-called closed position.

The vertical wall of the structure (A), on the wire inlet side, is provided with the retaining hooks (I) for the clamp. These are made so as to bend when the structure (A) is rotated and then return to their previous position, securing the structure (A) firmly to the printed circuit (D).

In this way it will be possible to close the clamp by means of a simple pressure, whereas to open it a tool must be used to bend the retaining hooks (I) and release them from the printed circuit (D).

In particular:
- In the so-called open position, the positioning hooks (B) of the clamp will be inserted in the holes (C) obtained on the printed circuit (D), leaving adequate space for inserting the cable or wire (E).
- In the so-called closed position, the clamp will lock the cable against the track (G), guaranteeing the mechanical seal and electric contact.

As an alternative solution, the structure (A) can be made of a non-metallic material, which would also guarantee electrical insulation of the parts.

The new clamp as described above has considerable advantages.

In view of the simplicity of the construction, the new clamp can be produced easily and cheaply by means of widely used and inexpensive processes such as punching.

Development of the product does not require the creation of any machine for assembly. The product does not have to be welded to the printed circuit and this fact reduces the production cost of the devices that use such a component. The product can be connected without using any tool, whereas to open the clamp a tool must be used, for example a screwdriver.

Therefore, with reference to the preceding description and the attached drawings, the following claims are made.

## Claims

1. Clamp for the connection of electric wires or cables (E) on a printed circuit (D), comprising a body or structure (A) suitable for being connected to said printed circuit (D), said body or structure (A) substantially resembling a portal and comprising at least one contact part or element (F) for pressing at least one electric wire (E) into the corresponding path or track (G) appropriately obtained on said printed circuit (D), **characterized in that** said contact and pressure element (F) comprises a flexible part or tab extending away from the upper part of said body or structure (A), said flexible part being turned downwards in order to exerting pressure on said at least one electric wire (E).

2. Clamp for the connection of electric wires or cables (E) on a printed circuit (D) according to claim 1, **characterised in that** said body or structure (A) comprises, in addition to said contact and pressure element (F), also one or more positioning hooks (B), suitable for insertion in holes or seats (C) correspondingly obtained on said printed circuit (D), and one or more retaining hooks (I), suitable for being connected to said printed circuit (D).

3. Clamp for the connection of electric wires or cables (E) on a printed circuit (D) according to claim 2, **characterised in that** said retaining hook (I) counteracts the elastic action of said flexible tab or part (F).

4. Clamp for the connection of electric wires or cables (E) on a printed circuit (D) according to claims 2, 3, **characterised in that** said retaining hook (I) is suitable for being hooked to the edge of the printed circuit (D).

5. Clamp for the connection of electric wires or cables (E) on a printed circuit (D) according to claims 2, 3, 4, **characterised in that** said positioning hooks (B) are located on the rear part of the structure (A) and said retaining hooks (I) are located on the front part of the structure (A).

6. Clamp for the connection of electric wires or cables (E) on a printed circuit (D) according to claims 2, 3, 4, 5, **characterised in that** said body or structure (A), connected to said printed circuit (D) by means of said positioning hooks (B), can be tilted with respect to the printed circuit (D) from a raised position, for insertion of at least one electric wire (E), to a closed position, in which said retaining hooks (I) rest on the lower edge of said printed circuit (D) and said tab (F) presses said electric wire (E) against said path or track (G).

7. Clamp for the connection of electric wires or cables (E) on a printed circuit (D) according to one or more of the preceding claims, **characterised in that** said body or structure (A) is obtained from one single element, metal or non-metal, punched and shaped or pressed/moulded.

## Patentansprüche

1. Klemme zur Verbindung von elektrischen Drähten oder Kabeln (E) an einer gedruckten Schaltung (D), umfassend einen Körper oder eine Struktur (A), der/die zur Verbindung mit der gedruckten Schaltung (D) geeignet ist, wobei der Körper oder die Struktur (A) im Wesentlichen einem Portal ähnelt und zumindest einen Kontaktabschnitt oder -element (F) umfasst, um zumindest einen elektrischen Draht (E) in die entsprechende Bahn oder Spur (G) zu drücken, die an der gedruckten Schaltung (D) passend ausgebildet ist, **dadurch gekennzeichnet, dass** das Kontakt- und Druckelement (F) einen biegsamen Abschnitt oder Lasche umfasst, der/die sich vom oberen Abschnitt des Körpers oder der Struktur (A) weg erstreckt, wobei der biegsame Abschnitt nach unten gerichtet ist, um auf den zumindest einen elektrischen Draht (E) Druck auszuüben.

2. Klemme zur Verbindung von elektrischen Drähten oder Kabeln (E) an einer gedruckten Schaltung (D) nach Anspruch 1, **dadurch gekennzeichnet, dass** der Körper oder die Struktur (A) zusätzlich zum Kontakt- und Druckelement (F) auch einen oder mehrere Positionierungshaken (B), die zur Einführung in Löcher oder Sitze (C) geeignet sind, die an der gedruckten Schaltung (D) entsprechend ausgebildet sind, sowie einen oder mehrere Haltehaken (I), die zur Verbindung mit der gedruckten Schaltung (D) geeignet sind, umfasst.

3. Klemme zur Verbindung von elektrischen Drähten oder Kabeln (E) an einer gedruckten Schaltung (D) nach Anspruch 2, **dadurch gekennzeichnet, dass** der Haltehaken (I) der elastischen Wirkung der biegsamen Lasche oder des biegsamen Abschnitts (F) entgegenwirkt.

4. Klemme zur Verbindung von elektrischen Drähten oder Kabeln (E) an einer gedruckten Schaltung (D) nach Anspruch 2 oder 3, **dadurch gekennzeichnet, dass** der Haltehaken (I) dazu geeignet ist, am Rand der gedruckten Schaltung (D) eingehakt zu werden.

5. Klemme zur Verbindung von elektrischen Drähten oder Kabeln (E) an einer gedruckten Schaltung (D) nach Anspruch 2, 3 oder 4, **dadurch gekennzeichnet, dass** die Positionierungshaken (B) am hinteren Abschnitt der Struktur (A) angeordnet sind und die Haltehaken (I) am vorderen Abschnitt der Struktur (A) angeordnet sind.

6. Klemme zur Verbindung von elektrischen Drähten oder Kabeln (E) an einer gedruckten Schaltung (D) nach Anspruch 2, 3, 4 oder 5, **dadurch gekennzeichnet, dass** der Körper oder die Struktur (A), der/die mittels der Positionierungshaken (B) mit der gedruckten Schaltung (D) verbunden ist, in Bezug auf die gedruckte Schaltung (D) von einer angehobenen Stellung zur Einführung von zumindest einem elektrischen Draht (E) in eine geschlossene Stellung, in der die Haltehaken (I) am unteren Rand der gedruckten Schaltung (D) anliegen und die Lasche (F) den elektrischen Draht an die Bahn oder Spur (G) drückt, gekippt werden kann.

7. Klemme zur Verbindung von elektrischen Drähten oder Kabeln (E) an einer gedruckten Schaltung (D) nach einem oder mehreren der vorangegangenen Ansprüche, **dadurch gekennzeichnet, dass** der Körper oder die Struktur (A) aus einem einzigen metallischen oder nichtmetallischen, gestanzten und zugeformten oder formgepressten/ -gegossenen Element gebildet ist.

## Revendications

1. Borne pour la connexion de câbles ou de fils électriques (E) sur un circuit imprimé (D), comprenant un corps ou structure (A), apte à être relié audit circuit imprimé (D), ledit corps ou structure (A) ressemblant essentiellement à un portail et comprenant au moins un élément ou partie de contact (F) afin de comprimer au moins un fil électrique (E) dans le chemin ou voie correspondant (G), opportunément obtenu dans ledit circuit imprimé (D), **caractérisée en ce que** ledit élément de contact et de pression (F) comprend une languette ou partie flexible sortant de la partie supérieure dudit corps ou structure (A), ladite partie flexible étant orientée vers le bas afin d'exercer une pression sur ledit au moins un fil électrique (E).

2. Borne pour la connexion de câbles ou fils électriques (E) sur un circuit imprimé (D) conformément à la revendication 1, **caractérisée en ce que** ledit corps ou structure (A) comprend, en plus dudit élément de contact et de pression (F), aussi un ou plusieurs crochets de positionnement (B), aptes à être insérés dans des trous ou logements (C) correspondants, obtenus sur ledit circuit imprimé (D), et un ou plusieurs crochets de retenue (I), aptes à être reliés audit circuit imprimé (D).

3. Borne pour la connexion de câbles ou fils électriques (E) sur un circuit imprimé (D) conformément à la revendication 2, **caractérisée en ce que** ledit crochet de retenue (I) compense l'action élastique de ladite languette ou partie flexible (F).

4. Borne pour la connexion de câbles ou fils électriques (E) sur un circuit imprimé (D) conformément aux revendications 2 et 3, **caractérisée en ce que** ledit crochet de retenue (I) est apte à être accroché au bord du circuit imprimé (D).

5. Borne pour la connexion de câbles ou fils électriques (E) sur un circuit imprimé (D) conformément aux revendications 2, 3 et 4, **caractérisée en ce que** lesdits crochets de positionnement (B) sont situés dans la partie arrière de la structure (A) et lesdits crochets de retenue (I) sont situés dans la partie avant de la structure (A).

6. Borne pour la connexion de câbles ou fils électriques (E) sur un circuit imprimé (D) conformément aux revendications 2, 3, 4 et 5, **caractérisée en ce que** ledit corps ou structure (A), relié audit circuit imprimé (D) à l'aide des dites crochets de positionnement (B), peut être incliné par rapport au circuit imprimé (D) d'une position relevée, en vue de l'insertion d'au moins un fil électrique (E), à une position fermée dans laquelle lesdits crochets de retenue (I) s'appuient sur le bord inférieur dudit circuit imprimé (D) et ladite languette (F) comprime ledit fil électrique (E) dans ledit chemin ou voie (G).

7. Borne pour la connexion de câbles ou fils électriques (E) sur un circuit imprimé (D) conformément à une ou plusieurs revendications dont ci-dessus, **caractérisée en ce que** ledit corps ou structure (A) est obtenu à partir d'un seul élément, métallique ou non métallique, poinçonné et façonné ou pressé/moulé.
